# EUROPEAN PATENT SPECIFICATION

(11) **EP 4 012 693 B1**
(45) Date of publication and mention of the grant of the patent: **20.09.2023**
(21) Application number: 21209316.5
(22) Date of filing: 19.11.2021
(51) Int. Cl.: G09F 11/12, G09F 11/16, G09F 9/30

(54) **DISPLAY DEVICE**
ANZEIGEVORRICHTUNG
DISPOSITIF D'AFFICHAGE

(30) Priority: 09.12.2020 KR 20200171610
(43) Date of publication of application: 15.06.2022
(73) Proprietor: LG Display Co., Ltd., Seoul 07336 (KR)
(72) Inventor: Seol, SeungWon, 10845 Gyeonggi-do (KR); Park, JongYoung, 10845 Gyeonggi-do (KR); Jung, Hyojin, 10845 Gyeonggi-do (KR)
(74) Representative: Ter Meer Steinmeister & Partner

(56) References cited:
- EP-A2- 3 367 675
- WO-A1-2014/114698
- KR-U- 20110 000 277
- US-B1- 7 806 490

## Description

### BACKGROUND

### Field

Embodiments of the present disclosure relate to a display device.

### Description of Related Art

In general, liquid crystal display (LCD) devices, plasma display devices, field emission display devices, and light emitting display devices are under active research as flat display devices. Among them, the LCD devices and the light emitting display devices have attracted attention in view of their benefits of mass production, ease of driving means, and high image quality.

However, such a display device has gradually increased in volume to meet the needs of users for a larger screen, thereby increasing a risk of damage to the display panel and requiring a larger space for installation which makes users difficult to secure the space.

In addition, in order to provide an always-on-display mode that continuously displays various information desired by the users, an always-on-display device is required in addition to a general display device in a normal mode, which makes it difficult to satisfy various users demand.

Therefore, to solve aforementioned problems and provide a display device which appeals more diverse use to users, there is a need for research on providing a display device engaged to furniture, equipment, facilities, etc., to implement various forms of display.

WO 2014/114698 A1 presents a retractable screen device with autonomous controlled speed lid opening, comprising an opening and closing mechanism, configured to open and close, by means of a lid, an opening, a screen which enables a resting position and a working position to be adopted and a translation mechanism configured to move the screen. Said opening and closing mechanism comprises a mechanical energy accumulator, which acts on the lid and a speed retention and control element linked to said accumulator and assisted by the movement of the screen. Said element keeps the lid closed in resting position and facilitates the autonomous and controlled opening of said lid upon moving the screen from the resting position to the working position.

KR 2011 0000277 U relates to a device for accommodating an LCD monitor, and a protective cover is installed on the upper side of a body that houses the monitor, and a joint and a crank means are connected to the protective cover by an operating rod, so that when the monitor rises, the protective cover is installed. It relates to an LCD monitor storage device that automatically opens and closes a protective cover that automatically opens and closes automatically when descending.

### BRIEF SUMMARY

Embodiments of the present disclosure provide a display device allowing a user to freely accommodate a display panel in a housing so as not to be externally exposed, or to change the display device between an always-on-display mode and a normal mode when the user needs.

Embodiments of the present disclosure also provide a display device configured to be mounted without being constrained by an additional mounting space, thereby using a space efficiently, and to reduce a risk of damage due to an external impact by minimizing the external exposure of the display panel, thereby satisfying various user demands.

The objectives of the embodiments of the present disclosure are not limited to what has been described above, and other unmentioned objectives will be clearly understood to those skilled in the art from the following description. The objects are achieved by the invention set out by the subject-matter of the independent claim(s).

In a first aspect of the present disclosure is provided a display device including a module housing accommodating a display panel pulled up and down, a moving plate accommodated in the module housing and pulled up and down with the display panel, a driving member pulling up and down the moving plate and the display panel, a fixed plate coupled to the inside of the module housing and to which the driving member is fixed.

According to embodiments of the present disclosure, there may be provided a display device allowing a user to freely accommodate a display panel in a housing so as not to be externally exposed, or to change the display device between an always-on-display mode and a normal mode when the user needs.

According to embodiments of the present disclosure, there may be provided a display device configured to be mounted without being constrained by an additional mounting space, thereby using a space efficiently, and to reduce a risk of damage due to an external impact by minimizing the external exposure of the display panel, thereby satisfying various user demands.

In a second aspect of the present technique a display device is provided. The display device includes: a module housing accommodating a display panel pulled up and down; a moving plate accommodated in the module housing and pulled up and down with the display panel, the moving plate has a front surface coupled to the display panel and a rear surface provided with moving brackets to which a driving belt coupled; a driving member pulling up and down the moving plate by winding or releasing the driving belt; and a fixed plate coupled to the inside of the module housing and to which the driving member is fixed.

In a third aspect of the present technique a display device comprising: a module housing accommodating a display panel and having an opening for moving or drawing the display panel out from and/or into the module housing therethrough; a moving plate accommodated in the module housing, the moving plate having the display panel seated thereon and provided with one or more moving brackets, a driving belt coupled to the one or more moving bracket for moving or drawing the moving plate along with the display panel out from and into the module housing via the opening of the module housing, a driving member for moving or drawing the moving plate by winding or releasing the driving belt; and a fixed plate coupled to an inside of the module housing and having the driving member fixed thereon. Optionally, the display panel may be seated on a front surface of the moving plate and/or a rear surface of the moving plate may be provided with the one or more moving brackets.

In a fourth aspect of the present technique a system or arrangement is provided comprising a main housing and a display device of any one of the aforementioned first, second and third aspects of the present technique.

The display device of any one of the aforementioned first, second and third aspects of the present technique, or the system or arrangement of the fourth aspect of the present technique may include one or more of the following features.

The moving brackets are provided with a through hole penetrated by a flexible circuit film connected to a source printed circuit board of the display panel.

A control printed circuit board to which the flexible circuit film penetrating the through hole is bent and connected may be fixed to the moving brackets.

A main board and/or a power board may be fixed to the fixed plate.

An image processor electrically connected to the control printed circuit board and supplying a data signal and a control signal may be mounted on the main board.

The power board may supply power to the display panel.

A position sensor may be coupled to the fixed plate to sense and transmit the position of the display panel to the main board.

The main board may control the display panel as an always-on-display mode when an end portion of the display panel is overlapped with a preset position.

The display device may further comprise: a cable penetrating member including one end coupled to the fixed plate and other end coupled to the moving plate.

A data cable connecting the main board and the control printed circuit board and/or a power cable connecting the power board and the control printed circuit board may penetrate the inside the cable penetrating member.

The cable penetrating member may include a plurality of connecting members rotatably connected to each other.

Each of the connecting members may have a couple of first connecting portions disposed opposite to each other and a couple of second connecting portions disposed opposite to each other.

The first connecting portions may be extended in one direction from a center portion provided with an empty space through which the data cable and/or the power cable may pass.

The second connecting portions may be extended in a direction opposite to the one direction from the center portion.

The first connecting portions may be provided with connecting holes.

The second connecting portions may be provided with rotation protrusions.

The first connecting portions and the second connecting portions may be overlapped with each other.

The first connecting portions and the second connecting portions are coupled when the rotation protrusions are inserted to the connecting holes.

The connecting members disposed at one end and/or the other end of the cable penetrating member may be provided with coupling holes.

The driving member may comprise a driving motor coupled to the fixed plate.

The driving member may comprise a driving gear and/or a driven gear rotated by the driving motor.

The driving member may comprise a driving pulley coupled coaxially to the driven gear to wind or release the driving belt,

The driving member may comprise driven pulleys connected to the driving pulley by the driving belt and coupled to the fixed plate.

The driving member may comprise guide bars each including opposite ends fixed to the module housing.

The driving member may comprise moving guides coupled to one side of the moving plate and pulled up and down along the guide bars, respectively.

The driving member may include elastic belts, having one end coupled to the moving guides and other end fixed to the module housing.

The driving member may include belt rollers fixed to the fixed plate.

The elastic belts may be wound on the belt rollers and rotatably supported by the belt rollers.

A sliding door which is closed when the display panel is moved in or drawn in and is opened when the display panel is moved out or drawn out by being slid in the front and rear directions of the module housing may be provided at the upper portion of the module housing.

The display device may comprise door levers each including one end coupled to the sliding door and other end rotatably coupled to the fixed plate.

Each of the door levers may be rotatably coupled to a hinge bracket coupled to the fixed plate with a hinge axis and may be supported by a sliding rail coupled to the moving plate by a rotation supporting member provided at a support hole of the door lever spaced apart from the hinge axis.

A guide groove into which the rotation supporting member is inserted may be provided inside of the sliding rail.

The guide groove may include a top guides groove and a bottom guide groove having parallel center lines, spaced apart from each other, and connected via a curved groove.

The module housing may be built in and fixed inside of a main housing.

The display panel may be pulled up to the upper portion of the main housing or pulled down from the upper portion of the main housing.

The display panel, the moving plate and/or the fixed plate may be sequentially stacked from a front side to a rear side of the module housing.

At least one, and preferable each, of the one or more moving brackets, comprises a through hole.

One or more flexible electric components such as a wire or a flexible circuit film, etc may be penetratingly arranged with or pass through the through-hole.

The flexible circuit film may pass through the through-hole and be connected to a source printed circuit board of the display panel.

The display device may comprise a control printed circuit board fixed to the moving brackets. The flexible circuit film may penetrate the through hole and be connected to the control printed circuit board
The display device may comprises at least one of: a main board and a power board.

The main board may be fixed to the fixed plate.

An image processor electrically connected to the control printed circuit board to supply a data signal and/or a control signal to the display panel may be mounted on the main board.

The power board may be fixed to the fixed plate.

The power board may be configured to supply power to the display panel.

In the present technique, 'fixed', 'coupled', 'connected', 'mounted' 'provided on' and related terms may be interchangeably used and may be understood as physically fixed, coupled, connected, etc. unless otherwise stated. When a component A is 'fixed' to/with/on/at, 'coupled' to/with/on/at, 'connected' to/with/on/at, 'mounted' to/with/on/at, 'provided' to/with/on/at another component B, then it means the two components A and B are connected to each other such that they remain at rest or move together as single unit/component/body, unless otherwise stated. In other words, the components A and B are disposed such that they are at rest or same relative position with respect to each other, at least at the mutual connection, unless otherwise stated. The components A and B can be any of the components of the display device of the aforementioned first, second and third aspects or arrangement/system of the aforementioned fourth aspect.

The display device may include a position sensor.

The position sensor may be coupled to the fixed plate and/or to the module housing and/or to the main housing.

The position sensor is configured to sense a position of the display panel with respect to the module housing and/or with respect to the fixed plate and/or with respect to the main housing.

The position sensor may transmit information relating to the position so sensed to the main board and/or to a controller.

The main board or the controller may be configured to control the display panel in different modes - such as an 'always-on-display' mode and/or a 'normal' mode and/or 'off' mode, based on the position of the display panel, for example as sensed by the position sensor, with respect to the module housing and/or with respect to the fixed plate and/or with respect to the main housing, for example based on a length of the display panel exposed outside or protruding out from/of the module housing and/or the main housing and/or the fixed plate and/or the opening of the module housing.

In the 'always-on-display' mode, the display panel may be at a first position with respect to the module housing and/or with respect to the fixed plate and/or with respect to the main housing. The first position may correspond to a first protruded length and/or a first exposed area of the display panel (i.e. length or area available for viewing by a user) with respect to the module housing and/or with respect to the fixed plate and/or with respect to the main housing.

In the 'normal' mode, the display panel may be at a second position with respect to the module housing and/or with respect to the fixed plate and/or with respect to the main housing. The second position may correspond to a second protruded length and/or a second exposed area of the display panel (i.e. length or area available for viewing by a user) with respect to the module housing and/or with respect to the fixed plate and/or with respect to the main housing.

The second protruded length and/or the second exposed area of the display panel may be greater than the first protruded length and/or the first exposed area of the display panel.

The 'off' mode of the display panel may be implemented based on express instruction of the user provided by a user interface, such as a remote, or may be implemented when the display panel is accommodated completely inside the module housing i.e. no area of the display panel is exposed outside the module housing.

The display device may further comprise a cable penetrating member.

The cable penetrating member may a flexible member within which at least a part of a cable such as signal line and/or power cable of the display device is arranged.

The cable penetrating member may enclose at lease a part of the cable extending or running therethrough.

The cable penetrating member may support the cable, i.e. a movement of the cable, when the display panel is drawn in and out, or moved in and out.

The cable penetrating member may include one end coupled to the fixed plate and/or the module housing and another end coupled to the moving plate and/or the display panel. The other end may thus move along with the moving plate and/or the display panel when the moving plate is moved to be drawn in and out, or drawn in and out, of the module housing.

The display device may comprise a data cable connecting the main board and the control printed circuit board, and/or a power cable connecting the power board and the control printed circuit board.

The data cable and/or the power cable may run through an inside of the cable penetrating member, and may be moved with the cable penetrating member.

The cable penetrating member may include a plurality of connecting members rotatably linked or connected to each other.

Each connecting member defined a center portion having an empty space through which the cable supported by the cable penetrating member such as the data cable and/or the power cable passes.

One or more, for example a couple of, first connecting portions may extend (or may be formed as extended or protruding or emanating) in one direction from the center portion. The couple of first connecting portion may be arranged opposite to each other or facing each other and the cable may run through the intervening gap or space.

One or more, for example a couple of, second connecting portions may extend (or may be formed as extended or protruding or emanating) in a direction from the center portion different than or opposite the one direction. The couple of second connecting portion may be arranged opposite to each other or facing each other and the cable may run through the intervening gap or space.

The first and the second connecting portions may be integrally formed with each other.

The first connecting portions and the second connecting portions of adjacent connecting members may be rotatably interlinked. For example, the first connecting portion may be provided with a connecting hole, and the second connecting portion may be provided with a corresponding rotation protrusion to be inserted into the connecting hole of the adjacent connecting portion.

The first connecting portion and the second connecting portion of adjacent connecting members may be arranged to partially overlapped with each other.

The first connecting portion and the second connecting portion of adjacent connecting members may be coupled by the rotation protrusions inserted into the corresponding connecting hole.

The connecting member, say a terminal connecting member, disposed at the one end of the cable penetrating member and/or the connecting member, say a terminal connecting member, disposed at the other end of the cable penetrating member may be provided with a coupling means for coupling the connecting member to the fixed plate and/or the moving bracket.

The driving member may comprise a driving motor coupled to the fixed plate and/or to the module housing. The driving motor may provide force to move the movable plate relative to the fixed plate and/or relative to the module housing and/or relative to the main housing.

The driving member may comprise a gear arrangement for example a driving gear and a driven gear. The gear arrangement may be driven by or rotated by the driving motor.

The driving member may comprise a driving pulley coupled to the driven gear to wind or release/unwind the driving belt.

The driving member may comprise one or more driven pulleys connected to the driving pulley by the driving belt and coupled to the fixed plate and/or to the module housing.

The driving member may further comprise one or more guide bars fixed to the module housing and/or to the fixed plate; and one or more moving guides coupled to the moving plate and configured to move along the one or more guide bars, respectively.

The one or more guide bars may guide the movement, e.g. translational movement, of the moving guides. The one or more moving guides may move along the guide bar.

At least a part of the guide bar may be received in the moving guide, and the moving guide may slide along the guide bar.

The driving member may include one or more elastic members such as one or more elastic belts.

Each elastic member or belt may have one end coupled to the one or more moving guides and/or to the moving plate, and other end (i.e. an opposite end) fixed to the module housing and/or to the fixed plate.

The elastic member may be tensioned by the movement of the moving plate relative to the module housing and/or to the fixed plate, for example when the moving plate is moved to be drawn into the module housing.

The elastic member or belt may provide a pull on the moving guide and/or the moving plate, when the moving plate is moved to be drawn out of the module housing.

One or more belt rollers may be fixed to the fixed plate and/or the module housing to support movement or elastic movement (tensioning/stretching and relaxing) of the elastic member or belt, during movement of the moving plate while being moved out or drawn out of and/or moved into or drawn into the module housing.

The belt rollers may roll or rotate and thus allow the movement or elastic movement (tensioning/stretching and relaxing) of the elastic member or belt while supporting the elastic member or belt.

The display device may include a door for covering i.e. opening and closing of the opening of the module housing.

The door may be hinged at the opening of the module housing and may rotate about the axis of the hinge to open and close the opening of the module housing.

The door may be hinged at a rear side of the module housing, i.e. a side at rear or non display side/face of the display panel, such that the door when opened is at a rear of the display panel, and thus out of the view of a viewer.

The door may be a sliding door.

The sliding door may be provided at the opening of the module housing.

The sliding door may be configured to close the opening of the module housing when the display panel is moved into or drawn into the module housing, and/or to open the opening of the module housing when the display panel is moved out or drawn out of the module housing, by being slid in a front and rear direction of the module housing.

The sliding door when opened may be at a rear of the display panel, and thus out of the view of a viewer. The sliding door may be at rear or at front of the display panel when opened.

The display device may further comprise one or more door levers, each including one end coupled to the sliding door and other end rotatably coupled to the fixed plate and/or to the module housing.

The display device may further comprising one or more hinge brackets coupled to the fixed plate and/or to the module housing.

Each of the door levers may be rotatably coupled to the hinge bracket and may be rotatable about a hinge axis.

Each of the door levers may include a support hole. A rotation supporting member may be provided at the support hole.

The display device may comprise a sliding rail coupled to the moving plate, and configured to support a rotational movement of the rotation supporting member of the door levers.

The sliding rail may include a guide groove into which the rotation supporting member may be inserted.

The rotation supporting member may move or rotate and/or locomote in the guide groove while being supported by the sliding rail, i.e. walls of the sliding rail defining the guide groove.

The guide groove includes a top guide groove and a bottom guide groove having parallel center lines, i.e. the top guide groove and a bottom guide groove may be parallel to each other. The top guide groove and the bottom guide groove may be connected via a curved groove disposed thereinbetween or extending between the top guide groove and the bottom guide groove.

The top guide groove, the curved groove, and the bottom guide groove may be serially arranged or end-to-end connected to each other to define the guide groove of the sliding rail.

The rotation supporting member may move from the bottom guide groove to the curved guide groove and then to the top guide groove, sequentially, when the door or the sliding door of the opening of the module housing is opened or slid to be opened.

The present application envisages an arrangement or a system comprising a main housing and the display device according to any one of the aforementioned first, second and third aspect.

The main housing may be part of a furniture.

The module housing may be built in and/or fixed inside and/or accommodated in and/or completely accommodated inside of the main housing.

The display panel when moved or drawn out from or of the module housing is movable relative to the main housing and is consequently moved or drawn out from or of the main housing to be exposed to a viewer.

The display panel, the moving plate and the fixed plate may be sequentially arranged or stacked from a front side to a rear side of the module housing, respectively.

In the present technique any reference to 'front' side or end may be understood as a side or end toward which a display side (where images are displayed i.e. having an active area of the display) of the display panel faces, i.e. front side of a component is a side or end that faces the same direction as the display side of the display panel faces, for example when moved or drawn out of the module housing. Similarly, 'back' side or end may be understood as a side or end opposite to the front side, i.e. on flip side of the front side, toward which a non-display side of the display panel faces, for example when moved or drawn out of the module housing.

The opening of the module housing through which the display panel and/or the moving plate is moved out or drawn out and moved in or drawn in may be positioned at an upper end or upper portion or top side/end of the display device.

The upper portion/end or top side/end may be understood with respect to a vertical direction in a state in which the display device or the arrangement is installed to be used.

The upper portion/end or top side/end may be understood with respect to a direction along which the display panel and/or the moving plate is moved or drawn out, or moved or drawn in with respect to the fixed plate and/or the module housing and/or the main housing. The upper portion/end or top side/end may be a lateral side or lateral end, and thus the display panel and/or the moving plate may optionally for example be moved or drawn out or moved or drawn in in non-vertical direction such as horizontal direction.

### DESCRIPTION OF DRAWINGS

FIGS. 1 and 2 are schematic views illustrating a display device according to embodiments of the present disclosure.
FIGS. 3 to 5 are perspective views illustrating a display device according to embodiments of the present disclosure.
FIG. 6 is a front view illustrating a display device according to embodiments of the present disclosure.
FIGS. 7 to 9 are perspective views illustrating a display device according to embodiments of the present disclosure.
FIG. 10 is an explanatory view illustrating an operating state of a display panel according to embodiments of the present disclosure.
FIG. 11 is a perspective view illustrating a display device according to embodiments of the present disclosure.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting", "make up of', and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after", "subsequent to", "next", "before", and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

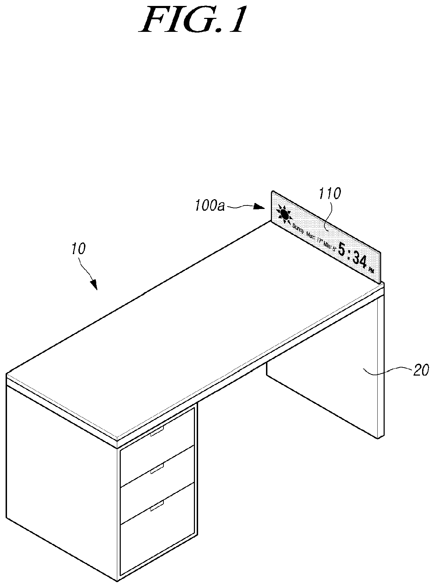

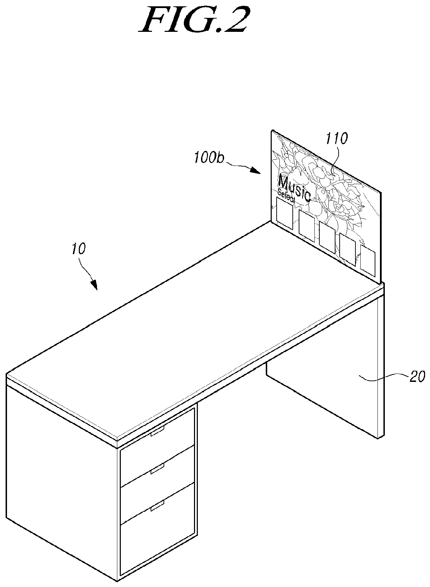

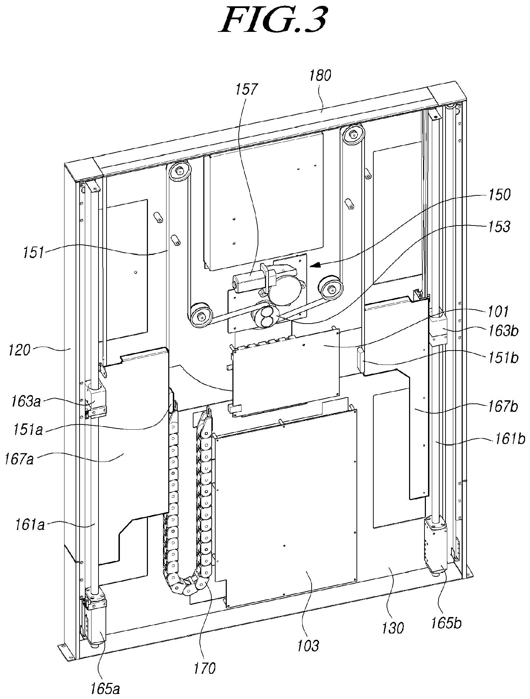

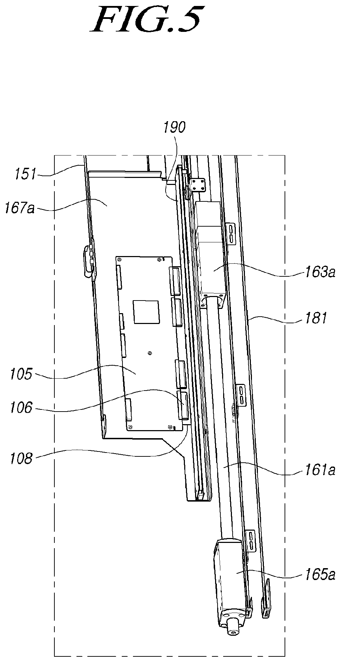

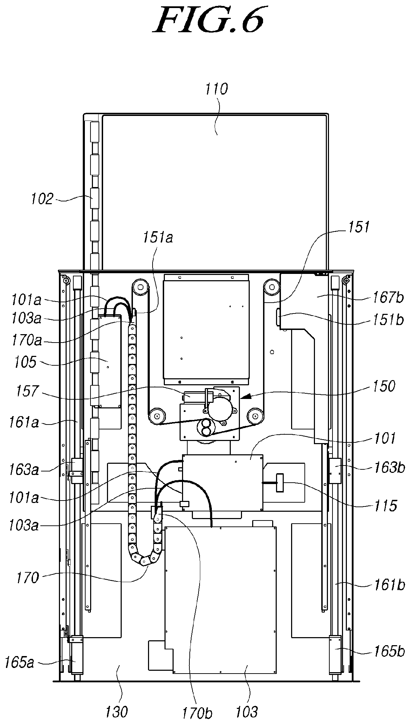

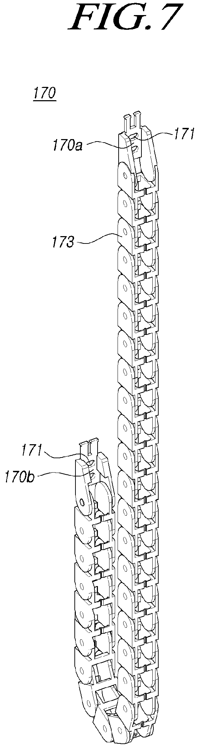

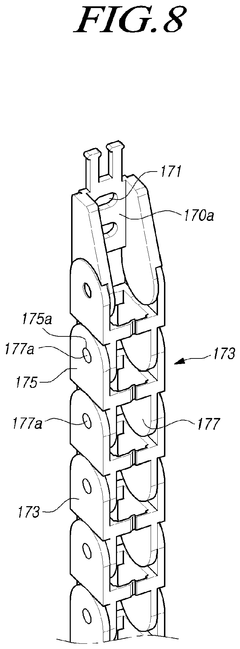

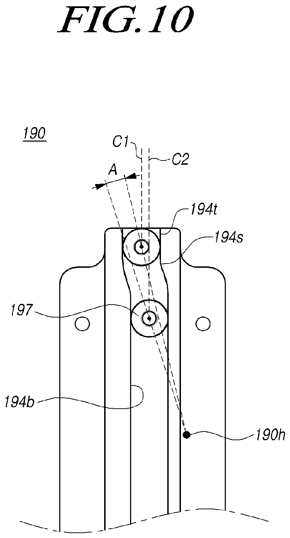

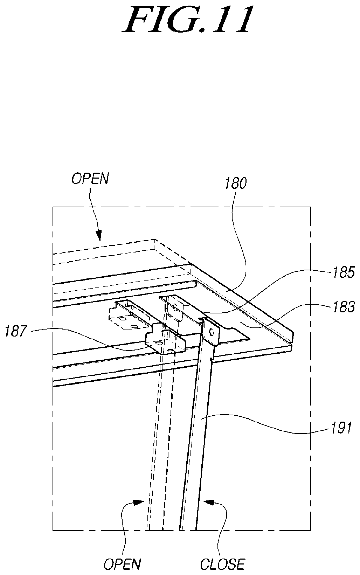

FIGS. 1 and 2 are schematic views illustrating a display device according to embodiments of the present disclosure. FIGS. 3 to 5 are perspective views illustrating a display device according to embodiments of the present disclosure. FIG. 6 is a front view illustrating a display device according to embodiments of the present disclosure. FIGS. 7 to 9 are perspective views illustrating a display device according to embodiments of the present disclosure. FIG. 10 is an explanatory view illustrating an operating state of a display panel according to embodiments of the present disclosure. FIG. 11 is a perspective view illustrating a display device according to embodiments of the present disclosure.

Referring to FIGS. 1 to 11, a display device according to embodiment of the present disclosure may include a module housing 120 accommodating a display panel 110 pulled up and down, a moving plate 140 accommodated in the module housing 120 and pulled up and down with the display panel 110, the moving plate 140 has a front surface coupled to the display panel 110 and a rear surface provided with moving brackets 167a, 167b to which a driving belt 151 coupled, a driving member 150 pulling up and down the moving plate 140 by winding or releasing the driving belt 151, a fixed plate 130 coupled to the inside of the module housing 120 and to which the driving member 150 is fixed.

Module housing 120 is built in and/or fixed inside of a main housing 10. The main housing 10 may be common furniture, equipment, facilities, etc.

Hereinafter, a display device according to embodiments of the present disclosure is given, wherein the module housing 120 is built in inside of a bottom support portion 20, corresponding to a leg of a table that is the most common furniture. The display panel 110 displays while the display panel 110 is pulled up to the upper portion of the table or pulled down from the upper portion of the table.

In addition, a display device according to embodiments of the present disclosure may provide either of an always-on-display mode (AOD mode), that continuously displays information such as a clock, weather or news, and a normal mode that displays an image or video intended by a user.

As illustrated in FIG. 1, in usual time, most of the display panel 110 is covered inside the module housing 120as only a portion of the display panel 110 is pulled up, and the always-on-display mode 100a may be provided.

FIG. 1 is illustrated, wherein the module housing 120 is installed by forming an empty space inside of the bottom support portion 20 of the main housing 10 when the always-on-display mode 100a is being provided.

FIG. 2 is illustrated, wherein the normal mode 100b is being provided, which hold the display screen to the full size as the display panel 110 is pulled up.

Module housing 120 has a rectangular shape in which the display panel 110, the moving plate 140, the driving member 150 and the fixed plate 130 are accommodated. The module housing 120 is partially omitted in the drawings for convenience of description.

The display panel 110, the moving plate 140, and the fixed plate 130 to which the driving member 150 is coupled are accommodated in the module housing 120 and/or sequentially stacked from the front side to the rear side of the module housing 120.

The display panel 110 is coupled to the front surface of the moving plate 140 and pulled up and down with the moving plate 140. According to embodiments of the present disclosure, the display panel 110 may be either an LCD panel or a light emitting display panel.

That is, when the display panel is an LCD panel, the display panel may further include a backlight unit irradiating light onto the LCD panel, a lower polarization plate attached to a lower substrate, and an upper polarization plate attached to the front surface of an upper substrate. The specific configurations of the lower substrate and the upper substrate may vary according to driving modes of the LCD panel, for example, twisted nematic (TN) mode, vertical alignment (VA) mode, in plane switching (IPS) mode, and fringe field switching (FFS) mode.

Further, when the display panel is a light emitting display panel, the light emitting display panel may include a lower substrate with a plurality of light emitting cells formed in the areas each of which is defined by gate lines, data lines, and power (VDD) lines, and an upper substrate bonded to the lower substrate face to face. Drawings and a detailed description of the light emitting display panel are not provided herein.

As described above, the display panel is not limited to any particular type in embodiments of the present disclosure. For example, the display panel may be made up of a flexible substrate to be bendable in embodiments of the present disclosure. The following description is given irrespective of display panel types.

The display panel 110 is coupled to the front surface of the moving plate 140, and the moving brackets 167a, 167b which is coupled to the driving belt 151 are provided in the rear surface of the moving plate 140. The moving plate 140 moves along guide bars 161a, 161b, to be described later, with the display panel 110 when the driving belt 151 is being wound or released by the moving member 150.

In addition, the moving bracket 167a, 167b are provided with a through hole 108, a flexible circuit film 106 connected to a source printed circuit board 102 of the display panel 110 is penetrated by the through hole 108. Thus, the display panel 110 and the moving plate 140 may be stably pulled up and down while the flexible circuit film 106 is connected to the control printed circuit board 105.

The moving brackets 167a, 167b are fixed to the opposite side of the moving plate 140. The moving brackets 167a, 167b are fixed to one end 151a and other end 151b of the driving belt 151, respectively, and pulled up and down with the moving plate 140.

The control printed circuit board 105 connected to the flexible circuit film 106 which is bent and passes through the through hole 108 is fixed to the rear surface of the one of the moving brackets 167a, 167b, for example, the moving bracket 167a. Thus, the control printed circuit board 105 connected to a main board 101 and/or a power board, to be described later, may be stably fixed when the moving plate 140 and the display panel 110 are pulled up and down.

A main board 110, on which an image processor electrically connected to the control printed circuit board 105 and supplying a data signal and/or a control signal is mounted, and/or a power board 103, which supplies power to the display panel 110, are fixed to the fixed plate 130, which is disposed at the rear to the moving plate 140.

In addition, a position sensor 115 coupled to the fixed plate 130 senses and transmits the position of the display panel 110 to the main board 101. The main board 101 controls the display panel 110 to either of the always-on-display mode and the normal mode according to the position of the display panel 110.

The position of the display panel 110 which determines the display panel 110 to the always-on-display mode may be set in advance. As illustrated in FIG. 1, embodiments of the present disclosure may be provided with the main board 101 controlling the display panel 110 as the always-on-display mode when the display panel 110 is pulled up to the preset position of the upper portion of the table, by the way of example.

A cable penetrating member 170 protecting a data cable 101a, which connects the main board 101 and the control printed circuit board 105, and/or a power cable 103a, which connects the power board 103 and the control printed circuit board 105, is provided.

The cable penetrating member 170 includes one end 170b coupled to the fixed plate 130 and other end 170a coupled to the moving bracket 167a of the moving plate 140. Thus, the other end 170a of the cable penetrating member 170 is pulled up and down with the moving plate 140.

The cable penetrating member 170 includes a plurality of connecting members 173 rotatably connected to each other. Each of the connecting members has an empty space formed therein so that the cables 101a, 103a may penetrate from the one end 170b to the other end 170a of the cable penetrating member 170. Thus, the cable penetrating member 170 maintains "U" shape, the lengths of both sides of which change when the moving plate 140 is being pulled up and down, thereby preventing the cables 101a, 103a from interference with surrounding electronic components while being pulled up and down.

Each of the connecting members 173 has a couple of first connecting portions 175 disposed opposite to each other and a couple of second connecting portions 177 disposed opposite to each other. The first connecting portions 175 are extended in one direction from a center portion provided with the empty space through which the cables 101a, 103a pass. The second connecting portions 177 are extended in the opposite direction from the center portion.

The first connecting portions 175 are provided with connecting holes 175a and are overlapped with the second connecting portions 177 of the nearby connecting member 173. The first connecting portion 175 and the second connecting portion 177 adjacent to each other are coupled as a rotation protrusion 177a is inserted to the connecting hole 175a.

The connecting member 173 disposed at the one end 170b and the other end 170a of the cable penetrating member 170 are provided with a coupling hole 171 so as to be coupled to the fixed plate 130 and the moving bracket 167a by a coupling member.

The driving member 150 pulling up and down the moving plate 140 includes, a driving motor 157 coupled to the fixed plate 130, a driving gear 156 and a driven gear 154 rotated by the driving motor 157, a driving pulley 153 coupled coaxially to the driven gear 154 to wind or release the driving belt 151, and driven pulleys 155a, 155b connected to the driving pulley 153 by the driving belt 151 and coupled to the fixed plate 130.

The driving motor 157 rotates the driving pulley 153 with the number of revolutions reduced by the constant gear ratio between the driving gear 156 and the driven gear 154. The opposite ends of the driving belt 151 are coupled to the driving pulley 153 to be wound in the same direction.

Therefore, the moving plate 140 and the display panel 110 are pulled up when the driving belt 151 is wound as the driving pulley 153 rotates in one direction, and the moving plate 140 and the display panel 110 are pulled down when the driving belt 151 is released as the driving pulley 153 rotates in opposite direction.

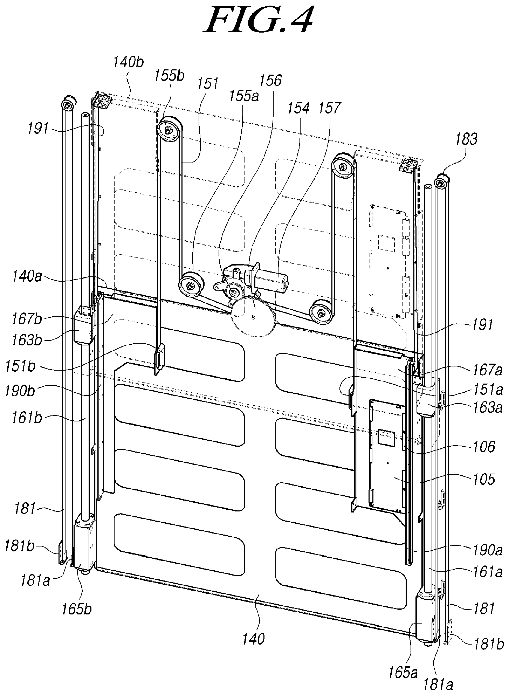

That is, when the driving pulley 153 rotates in a clockwise direction in FIG. 3 which illustrates the front direction of the fixed plate 130 or when the driving pulley 153 rotates in a counterclockwise direction in FIG. 4 which illustrates the rear direction of the moving plate 140, the moving plate 140 and the display panel 110 are pulled up.

In addition, the driving member 150 may further includes guide bars 161a, 161b each including opposite ends fixed to the module housing 120, and moving guides 165a, 165b coupled to one side of the moving plate 140 and pulled up and down along the guide bars 161a, 161b.

The moving guide 165a, 165b coupled to the moving plate 140 are pulled up and down along the guide bars 161a, 161b. Thus, the moving plate 140 is stably pulled up and down without being biased to either side while the driving force of the driving motor 157 pulls up and down the moving plate 140 via the driving belt 151.

The guide bars 161a, 161b and/or the moving guides 165a, 165b are disposed at the opposite sides of the module housing 120 and guide the moving plate 140 to be pulled up and down. Stoppers 163a, 163b are provided nearby the middle of the guide bars 161a, 161b, respectively, to limit the height of the moving guides 165a, 165.

FIG. 4 illustrates the moving plate 140 is being pulled up from the pulled down position 140a to the pulled up position 140b. FIG. 6 illustrates the display panel 110 at the pulled up position 140b.

In addition, the driving member 150 may further includes elastic belts 181, having one end 181a coupled to the moving guide 165a, 165b and other end 181b fixed to the module housing 120, and belt rollers 183 fixed to the fixed plate 130 and the elastic belts 181 are wound on the belt rollers 183 and rotatably supported by the belt rollers 183.

The elastic belts 181 are configured to provide a tensile force to the moving plate 140 at the pulled down position. Thus, the driving force of the driving motor 157 is assisted by the tensile force of the elastic belts 181 when the moving plate is being pulled up.

Therefore, a force to pull up the moving plate 140 is reduced when the moving plate 140 is being pulled up, and the moving plate 140 is maintained horizontally while being pulled up and down.

Meanwhile, a sliding door 180 which is closed when the display panel 110 is drawn in and is opened when the display panel 110 is drawn out by being slid in the front and rear directions of the module housing 120 to pull up the display panel 110 is provided at the upper portion of the module housing 120. Thus, the display panel 110 may not be exposed outside or may be in the always-on-display mode illustrated in FIG. 1.

The sliding door 180 is opened by being slid in the front and rear directions of the module housing 120. Door levers 191 each includes one end coupled to the sliding door 180 and other end rotatably coupled to the fixed plate 130 are provided.

Each of the door levers 191 is rotatably coupled to a hinge bracket 133 coupled to the fixed plate 130 via a hinge axis 190h, and is supported by a sliding rail 190 coupled to the moving plate 140 by a rotation supporting member 197 provided at a support hole 193 of the door lever 191 spaced apart from the hinge axis 190h. Wherein, the sliding rail 190 at two sides of the moving plate 140 are the sliding rail 190a and the sliding rail 190b respectively.

The rotation supporting member 197 may be a roller or a bearing. The rotation supporting shaft 195 is rotatably coupled to the support hole 193.

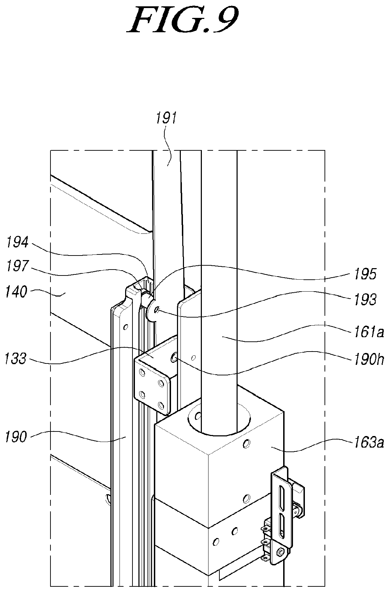

As illustrated in FIG. 9, a guide groove 194 into which the rotation supporting member 197 is inserted is provided inside of the sliding rail 190. As illustrated in FIG. 10, the guide groove 194 includes a top guide groove 194t and a bottom guide groove 194b having parallel center lines C1, C2 and connected via a curved groove 194s.

The center line C1 of the top guide groove 194t and the center line C2 of the bottom guide groove 194b are disposed parallel with a constant distance. The rotation supporting member 197 inserted into the guide groove 194 is provided at the opposite sides of the top guide groove 194t or the opposite sides of the bottom guide groove 194b.

Therefore, the rotation supporting member 197 moves along the top guide groove 194t, the curved groove 194s, and the bottom guide groove 194b when the sliding rail 190 is pulled up and down with the moving plate 140. The door lever 191 is rotated with a predetermined angle A about the hinge shaft 190h as the rotation support member 197 moves, so that the sliding door 180 is opened or closed.

As illustrated in FIG. 11, a door plate 183 provided with a moving hole 185 configured to enable the door lever 191 to move is coupled to the module housing 120 beneath the sliding door 180. A door guide 187 guiding the sliding door 180 is coupled to the sliding door 180 and moves along a coupling hole of the door plate 183.

Therefore, the display panel 110 is protected from an external impact and occupies minimized space as the sliding door 180 closed the upper portion of the module housing 120 when accommodating the display panel 110 into the main housing 10 so as not to be exposed outside.

As described above, according to embodiments of the present disclosure, there may be provided a display device allowing a user to freely accommodate a display panel in a housing so as not to be externally exposed, or to change the display device between an always-on-display mode and a normal mode when the user needs.

Further, according to embodiments of the present disclosure, there may be provided a display device configured to be mounted without being constrained by an additional mounting space, thereby using a space efficiently, and to reduce a risk of damage due to an external impact by minimizing the external exposure of the display panel, thereby satisfying various user demands.

The above description has been presented to enable any person skilled in the art to make and use the technical idea of the present invention, and has been provided in the context of a particular application and its requirements. Various modifications, additions and substitutions to the described embodiments will be readily apparent to those skilled in the art, and the general principles defined herein may be applied to other embodiments and applications without departing from the scope of the present invention. The above description and the accompanying drawings provide an example of the technical idea of the present invention for illustrative purposes only. That is, the disclosed embodiments are intended to illustrate the scope of the technical idea of the present invention. Thus, the scope of the present invention is not limited to the embodiments shown, but is to be accorded the widest scope consistent with the claims. The scope of protection of the present invention should be construed based on the following claims.

## Claims

1. A display device comprising:
a module housing (120) accommodating a display panel (110) and having an opening for moving the display panel (110) out from and into the module housing (120) therethrough;
a moving plate (140) accommodated in the module housing (120), the moving plate (140) having the display panel (110) seated thereon and provided with one or more moving brackets (167a, 167b);
a driving belt (151) coupled to the one or more moving bracket (167a, 167b) for moving the moving plate (140) along with the display panel (110) out from and into the module housing (120) via the opening of the module housing (20);
a driving member (150) for moving the moving plate (140) by winding or releasing the driving belt (151); and
a fixed plate (130) coupled to an inside of the module housing (120) and having the driving member (150) fixed thereon;
**characterized in that**:
at least one of the one or more moving brackets (167a, 167b) comprises a through hole (108), and the display device comprises a flexible circuit film (106) arranged penetrating the through hole (108).

2. The display device according to claim 1,
wherein the flexible circuit film (106) is connected to a source printed circuit board (102) of the display panel (110); and/or
wherein the display device comprises a control printed circuit board (105) fixed to the moving brackets (167a, 167b), and wherein the flexible circuit film (106) penetrating the through hole (108) is bent and connected to the control printed circuit board (105).

3. The display device according to claim 2, wherein the display device comprises at least one of:
a main board (101) fixed to the fixed plate (130), wherein the main board (101) is configured to supply a data signal and/or a control signal to the display panel (110) and is electrically connected to the control printed circuit board (105); and
a power board (103) fixed to the fixed plate (130), wherein the power board (103) is configured to supply power to the display panel (110).

4. The display device according to claim 3, comprising a position sensor (115) coupled to the fixed plate (130) and configured to sense and transmit a position of the display panel (110) with respect to the module housing (120) to the main board (101); and/or
wherein the main board (101) is configured to control the display panel (110) in an always-on-display mode and/or a normal mode, based on a length of the display panel (110) exposed outside the module housing (120).

5. The display device according to claim 3 or 4, wherein the display device further comprises:
a cable penetrating member (170) including one end (170b) coupled to the fixed plate (130) and other end (170a) coupled to the moving plate (140) to move along with the moving plate (140); and
wherein the display device comprises a data cable (101a) connecting the main board (101) and the control printed circuit board (105), and/or a power cable (103a) connecting the power board (103) and the control printed circuit board (105), and
wherein the data cable (101a) and/or the power cable (103a) are run through an inside of the cable penetrating member (170).

6. The display device according to claim 5, wherein the cable penetrating member (170) includes:
a plurality of connecting members (173) rotatably connected to each other, each connecting member (173) having:
a center portion defining an empty space through which the data cable (101a) and/or the power cable (103a) pass;
one or more first connecting portions (175) extended in one direction from the center portion; and
one or more second connecting portions (177) extended in a direction opposite to the one direction from the center portion.

7. The display device according to claim 6,
wherein the one or more first connecting portions (175) are provided with one or more connecting holes (175a), and the one or more second connecting portions (177) are provided with one or more rotation protrusions (177a), and wherein the one or more first connecting portions (175) and the one or more second connecting portions (177) are overlapped with each other and are coupled by the one or more rotation protrusions (177a) inserted into the one or more connecting holes (175a); and/or
wherein the connecting member (173) disposed at the one end (170b) of the cable penetrating member (170) and/or the connecting member (173) disposed at the other end (170a) of the cable penetrating member (170) is provided with a coupling hole (171) to couple the connecting member (173) to the fixed plate (130) and/or the moving plate.

8. The display device according to any one of the preceding claims, wherein the driving member (150) comprises:
a driving motor (157) coupled to the fixed plate (130);
a driving gear (156) and a driven gear (154) rotated by the driving motor (157);
a driving pulley (153) coupled to the driven gear (154) to wind or release the driving belt (151); and
one or more driven pulleys (155a, 155b) connected to the driving pulley (153) by the driving belt (151) and coupled to the fixed plate (130).

9. The display device according to claim 8, wherein the driving member (150) further comprises:
one or more guide bars (161a, 161b) fixed to the module housing (120); and
one or more moving guides (165a, 165b) coupled to the moving plate (140) and configured to move along the one or more guide bars (161a, 161b), respectively.

10. The display device according to claim 9, wherein the driving member (150) includes:
one or more elastic belts (181), each having one end (181a) coupled to the one or more moving guides (165a, 165b) and other end (181b) fixed to the module housing (120); and
one or more belt rollers (183) fixed to the fixed plate (130), and the one or more elastic belts (181) are rotatably supported by the one or more belt rollers (183).

11. The display device according to any one of the preceding claims, comprising:
a sliding door (180) provided at the opening of the module housing (120) and configured to close the opening of the module housing (120) when the display panel (110) is moved into the module housing (120) and/or to open the opening of the module housing (120) when the display panel (110) is moved out of the module housing (120), by being slid in a front and rear direction of the module housing (120).

12. The display device according to claim 11, wherein the display device further comprises:
one or more door levers (191), each including one end coupled to the sliding door (180) and other end rotatably coupled to the fixed plate (130).

13. The display device according to claim 12, comprising one or more hinge brackets (133) coupled to the fixed plate (130), wherein each of the door levers (191) is rotatably coupled to the hinge bracket (133) and is rotatable about a hinge axis (190h); and
wherein each of the door levers (191) includes a support hole (193), and a rotation supporting member (197) provided at the support hole (193); and
wherein display device comprises a sliding rail (190) coupled to the moving plate (140) and configured to support a movement of the rotation supporting member (197) of the door levers (191).

14. The display device according to claim 13, wherein a guide groove (194) into which the rotation supporting member (197) is inserted is provided inside of the sliding rail (190); or
wherein a guide groove (194) into which the rotation supporting member (197) is inserted is provided inside of the sliding rail (190), wherein the guide groove (194) includes a top guide groove (194t) and a bottom guide groove (194b) having parallel center lines (C1, C2), and wherein the top guide groove (194t) and the bottom guide groove (194b) are connected via a curved groove (194s) disposed thereinbetween.

15. An arrangement comprising a main housing (10) and the display device according to any one of the preceding claims, wherein the module housing (120) is built in and/or fixed to the main housing (10), and wherein the display panel (110) is movable relative to the main housing (10) by being moved out from and moved into the module housing (120); and/or
wherein the display panel (110), the moving plate (140) and the fixed plate (130) are sequentially stacked from a front side to a rear side of the module housing (120).

## Patentansprüche

1. Anzeigevorrichtung, die Folgendes umfasst:
ein Modulgehäuse (120), das eine Anzeigetafel (110) aufnimmt und eine Öffnung aufweist, um die Anzeigetafel (110) durch diese aus dem und in das Modulgehäuse (120) zu bewegen;
eine bewegliche Platte (140), die im Modulgehäuse (120) aufgenommen ist, wobei die Anzeigetafel (110) auf der beweglichen Platte (140) sitzt und diese mit einer oder mehreren beweglichen Halterungen (167a, 167b) versehen ist;
einen Antriebsriemen (151), der zum Bewegen der beweglichen Platte (140) zusammen mit der Anzeigetafel (110) aus dem und in das Modulgehäuse (120) durch die Öffnung des Modulgehäuses (120) mit der einen oder den mehreren beweglichen Halterungen (167a, 167b) gekoppelt ist;
ein Antriebselement (150) zum Bewegen der beweglichen Platte (140) durch Aufwickeln oder Freigeben des Antriebsriemens (151); und
eine feste Platte (130), die mit einer Innenseite des Modulgehäuses (120) gekoppelt ist und woran das Antriebselement (150) befestigt ist;
**dadurch gekennzeichnet, dass**:
mindestens eine der einen oder mehreren beweglichen Halterungen (167a, 167b) ein Durchgangsloch (108) umfasst und die Anzeigevorrichtung einen flexiblen Schaltungsfilm (106), der das Durchgangsloch (108) durchdringend angeordnet ist, umfasst.

2. Anzeigevorrichtung nach Anspruch 1,
wobei der flexible Schaltungsfilm (106) mit einer gedruckten Quellenleiterplatte (102) der Anzeigetafel (110) verbunden ist; und/oder
wobei die Anzeigevorrichtung eine gedruckte Steuerleiterplatte (105) umfasst, die an den beweglichen Halterungen (167a, 167b) befestigt ist, und wobei der flexible Schaltungsfilm (106), der das Durchgangsloch (108) durchdringt, gebogen und mit der gedruckten Steuerleiterplatte (105) verbunden ist.

3. Anzeigevorrichtung nach Anspruch 2, wobei die Anzeigevorrichtung Folgendes umfasst:
eine Hauptplatine (101), die an der festen Platte (130) befestigt ist, wobei die Hauptplatine (101) konfiguriert ist, der Anzeigetafel (110) ein Datensignal und/oder ein Steuersignal zuzuführen, und mit der gedruckten Steuerleiterplatte (105) elektrisch verbunden ist; und/oder
eine Netzplatine (103), die an der festen Platte (130) befestigt ist, wobei die Netzplatine (103) konfiguriert ist, der Anzeigetafel (110) Energie zuzuführen.

4. Anzeigevorrichtung nach Anspruch 3, die einen Positionssensor (115) umfasst, der mit der festen Platte (130) gekoppelt ist und konfiguriert ist, eine Position der Anzeigetafel (110) in Bezug auf das Modulgehäuse (120) zu erfassen und an die Hauptplatine (101) zu übertragen; und/oder
wobei die Hauptplatine (101) konfiguriert ist, die Anzeigetafel (110) auf der Grundlage einer Länge der Anzeigetafel (110), die außerhalb des Modulgehäuses (120) angeordnet ist, in einer immer eingeschalteten Anzeigebetriebsart und/oder einer regulären Betriebsart zu steuern.

5. Anzeigevorrichtung nach Anspruch 3 oder 4, wobei die Anzeigevorrichtung ferner Folgendes umfasst:
ein Kabeldurchführungselement (170), das ein Ende (170b), das mit der festen Platte (130) gekoppelt ist, und ein anderes Ende (170a), das mit der beweglichen Platte (140) gekoppelt ist, derart, dass es sich zusammen mit der beweglichen Platte (140) bewegt, enthält; und
wobei die Anzeigevorrichtung ein Datenkabel (101a), das die Hauptplatine (101) und die gedruckte Steuerleiterplatte (105) verbindet, und/oder ein Netzkabel (103a), das die Netzplatine (103) und die gedruckte Steuerleiterplatte (105) verbindet, umfasst, und
wobei das Datenkabel (101a) und/oder das Netzkabel (103a) durch einen Innenraum des Kabeldurchführungselements (170) geführt werden.

6. Anzeigevorrichtung nach Anspruch 5, wobei das Kabeldurchführungselement (170) Folgendes enthält:
mehrere Verbindungselemente (173), die drehbar miteinander verbunden sind, wobei jedes Verbindungselement (173) Folgendes aufweist:
einen Mittelabschnitt, der einen leeren Raum definiert, durch den das Datenkabel (101a) und/oder das Netzkabel (103a) verlaufen;
einen oder mehrere erste Verbindungsabschnitte (175), die sich in einer Richtung vom Mittelabschnitt erstrecken; und
einen oder mehrere zweite Verbindungsabschnitte (177), die sich in einer Richtung, die zu der einen Richtung entgegengesetzt ist, vom Mittelabschnitt erstrecken.

7. Anzeigevorrichtung nach Anspruch 6,
wobei der eine oder die mehreren ersten Verbindungsabschnitte (175) mit einem oder mehreren Verbindungslöchern (175a) versehen sind und der eine oder die mehreren zweiten Verbindungsabschnitte (177) mit einem oder mehreren Drehvorsprüngen (177a) versehen sind und wobei der eine oder die mehreren ersten Verbindungsabschnitte (175) und der eine oder die mehreren zweiten Verbindungsabschnitte (177) miteinander überlappt sind und dadurch gekoppelt sind, dass der eine oder die mehreren Drehvorsprünge (177a) in das eine oder die mehreren Verbindungslöcher (175a) eingesetzt sind; und/oder
wobei das Verbindungselement (173), das an dem einen Ende (170b) des Kabeldurchführungselements (170) angeordnet ist, und/oder das Verbindungselement (173), das am anderen Ende (170a) des Kabeldurchführungselements (170) angeordnet ist, mit einem Kopplungsloch (171) versehen ist, um das Verbindungselement (173) mit der festen Platte (130) und/oder der beweglichen Platte zu koppeln.

8. Anzeigevorrichtung nach einem der vorhergehenden Ansprüche, wobei das Antriebselement (150) Folgendes umfasst:
einen Antriebsmotor (157), der mit der festen Platte (130) gekoppelt ist;
ein Antriebszahnrad (156) und ein angetriebenes Zahnrad (154), das durch den Antriebsmotor (157) gedreht wird;
eine Antriebsriemenscheibe (153), die mit dem angetriebenen Zahnrad (154) gekoppelt ist, um den Antriebsriemen (151) aufzuwickeln oder freizugeben; und
eine oder mehrere angetriebene Riemenscheiben (155a, 155b), die über den Antriebsriemen (151) mit der Antriebsriemenscheibe (153) verbunden sind und mit der festen Platte (130) gekoppelt sind.

9. Anzeigevorrichtung nach Anspruch 8, wobei das Antriebselement (150) ferner Folgendes umfasst:
einen oder mehrere Führungsstäbe (161a, 161b), die am Modulgehäuse (120) befestigt sind; und
eine oder mehrere bewegliche Führungen (165a, 165b), die mit der beweglichen Platte (140) gekoppelt sind und konfiguriert sind, sich jeweils zusammen mit dem einen oder den mehreren Führungsstäben (161a, 161b) zu bewegen.

10. Anzeigevorrichtung nach Anspruch 9, wobei das Antriebselement (150) Folgendes enthält:
einen oder mehrere elastische Riemen (181), die jeweils ein Ende (181a), das mit der einen oder den mehreren beweglichen Führungen (165a, 165b) gekoppelt ist, und ein anderes Ende (181b), das am Modulgehäuse (120) befestigt ist, aufweisen; und
eine oder mehrere Riemenscheiben (183), die an der festen Platte (130) befestigt sind und wobei der eine oder die mehreren elastischen Riemen (181) durch die eine oder die mehreren Riemenscheiben (183) drehbar getragen werden.

11. Anzeigevorrichtung nach einem der vorhergehenden Ansprüche, die Folgendes umfasst:
eine Schiebetür (180), die an der Öffnung des Modulgehäuses (120) vorgesehen ist und konfiguriert ist, die Öffnung des Modulgehäuses (120) zu verschließen, wenn die Anzeigetafel (110) in das Modulgehäuse (120) bewegt wird, und/oder die Öffnung des Modulgehäuses (120) zu öffnen, wenn die Anzeigetafel (110) aus dem Modulgehäuse (120) bewegt wird, indem sie in einer Vorne-Hinten-Richtung des Modulgehäuses (120) geschoben wird.

12. Anzeigevorrichtung nach Anspruch 11, wobei die Anzeigevorrichtung ferner Folgendes umfasst:
einen oder mehrere Türhebel (191), die jeweils ein Ende, das mit der Schiebetür (180) gekoppelt ist, und ein anderes Ende, das mit der festen Platte (130) drehbar gekoppelt ist, enthalten.

13. Anzeigevorrichtung nach Anspruch 12, die eine oder mehrere Scharnierhalterungen (133) umfasst, die mit der festen Platte (130) gekoppelt sind, wobei die Türhebel (191) jeweils mit der Scharnierhalterung (133) drehbar gekoppelt sind und um eine Scharnierachse (190h) drehbar sind; und
wobei die Türhebel (191) jeweils ein Trägerloch (193) und ein Drehungsträgerelement (197), das am Trägerloch (193) vorgesehen ist, enthalten; und
wobei die Anzeigevorrichtung eine Gleitschiene (190) umfasst, die mit der beweglichen Platte (140) gekoppelt ist und konfiguriert ist, eine Bewegung des Drehungsträgerelements (197) der Türhebel (191) zu tragen.

14. Anzeigevorrichtung nach Anspruch 13, wobei eine Führungsrille (194), in die das Drehungsträgerelement (197) eingesetzt ist, im Inneren der Gleitschiene (190) vorgesehen ist; oder
wobei eine Führungsrille (194), in die das Drehungsträgerelement (197) eingesetzt ist, im Inneren der Gleitschiene (190) vorgesehen ist, wobei die Führungsrille (194) eine obere Führungsrille (194t) und eine untere Führungsrille (194b) enthält, die parallele Mittellinien (C1, C2) aufweisen, und wobei die obere Führungsrille (194t) und die untere Führungsrille (194b) über eine gekrümmte Rille (194s) verbunden sind, die dazwischen angeordnet ist.

15. Anordnung, die ein Hauptgehäuse (10) und die Anzeigevorrichtung nach einem der vorhergehenden Ansprüche umfasst, wobei das Modulgehäuse (120) im Hauptgehäuse (10) eingebaut und/oder daran befestigt ist und wobei die Anzeigetafel (110) in Bezug auf das Hauptgehäuse (10) beweglich ist, indem sie aus dem und in das Modulgehäuse (120) bewegt wird; und/oder
wobei die Anzeigetafel (110), die bewegliche Platte (140) und die feste Platte (130) ausgehend von einer Vorderseite zu einer Rückseite des Modulgehäuses (120) aufeinanderfolgend gestapelt sind.

## Revendications

1. Dispositif d'affichage comprenant :
une enceinte modulaire (120) logeant un panneau d'affichage (110) et présentant une ouverture permettant de sortir et de rentrer à travers celle-ci le panneau d'affichage (110) hors de et dans l'enceinte modulaire (120) ;
une plaque mobile (140) logée dans l'enceinte modulaire (120), la plaque mobile (140) ayant le panneau d'affichage (110) placé sur elle et étant munie d'une ou de plusieurs consoles mobiles (167a, 167b) ;
une courroie d'entraînement (151) accouplée à ladite/auxdites une ou plusieurs consoles mobiles (167a, 167b) pour sortir et rentrer la plaque mobile (140) conjointement avec le panneau d'affichage (110) hors de et dans l'enceinte modulaire (120) via l'ouverture de l'enceinte modulaire (20) ;
un élément d'entraînement (150) pour mouvoir la plaque mobile (140) par enroulement ou déroulement de la courroie d'entraînement (151) ; et
une plaque fixe (130) accouplée à un intérieur de l'enceinte modulaire (120) et ayant l'élément d'entraînement (150) fixé sur elle ;
**caractérisé en ce que** :
au moins l'une desdites une ou plusieurs consoles mobiles (167a, 167b) comprend un orifice traversant (108), et le dispositif d'affichage comprend un film à circuit flexible (106) disposé en pénétrant dans l'orifice traversant (108).

2. Dispositif d'affichage selon la revendication 1,
dans lequel le film à circuit flexible circuit (106) est connecté à une carte à circuit imprimé source (102) du panneau d'affichage (110) ; et/ou
dans lequel le dispositif d'affichage comprend une carte à circuit imprimé de commande (105) fixée aux consoles mobiles (167a, 167b), et dans lequel le film à circuit flexible (106) pénétrant dans l'orifice traversant (108) est courbé et connecté à la carte à circuit imprimé de commande (105).

3. Dispositif d'affichage selon la revendication 2, dans lequel le dispositif d'affichage comprend au moins une parmi :
une carte principale (101) fixée à la plaque fixe (130), la carte principale (101) étant configurée pour fournir un signal de données et/ou un signal de commande au panneau d'affichage (110) et étant connectée électriquement à la carte à circuit imprimé de commande (105) ; et
une carte d'alimentation (103) fixée à la plaque fixe (130), la carte d'alimentation (103) étant configurée pour fournir du courant au panneau d'affichage (110).

4. Dispositif d'affichage selon la revendication 3, comprenant un capteur de position (115) accouplé à la plaque fixe (130) et configuré pour détecter et transmettre à la carte principale (101) une position du panneau d'affichage (110) par rapport à l'enceinte modulaire (120) ; et/ou
dans lequel la carte principale (101) est configurée pour commander le panneau d'affichage (110) en un mode toujours-en-affichage et/ou un mode normal, sur la base d'une longueur du panneau d'affichage (110) exposé hors de l'enceinte modulaire (120).

5. Dispositif d'affichage selon la revendication 3 ou 4, dans lequel le dispositif d'affichage comprend en outre :
un élément pénétrant (170) à câble(s) incluant une extrémité (170b) accouplée à la plaque fixe (130) et l'autre extrémité (170a) accouplée à la plaque mobile (140) pour se déplacer conjointement avec la plaque mobile (140) ; et
dans lequel le dispositif d'affichage comprend un câble de données (101a) reliant la carte principale (101) et la carte à circuit imprimé de commande (105), et/ou un câble d'alimentation (103a) reliant la carte d'alimentation (103) et la carte à circuit imprimé de commande (105), et
dans lequel le câble de données (101a) et/ou le câble d'alimentation (103a) sont passés dans un intérieur de l'élément (170) pénétrant à câble(s).

6. Dispositif d'affichage selon la revendication 5, dans lequel l'élément pénétrant (170) à câble(s) inclut :
une pluralité d'éléments de connexion (173) connectés les uns aux autres de manière à pouvoir tourner, chaque élément de connexion (173) ayant :
une partie centrale définissant un espace vide à travers lequel passe(nt) le câble de données (101a) et/ou le câble d'alimentation (103a) ;
une ou plusieurs premières parties de connexion (175) s'étendant dans une direction à partir de la partie centrale ; et
une ou plusieurs secondes parties de connexion (177) s'étendant dans une direction opposée à ladite une direction à partir de la partie centrale.

7. Dispositif d'affichage selon la revendication 6,
dans lequel lesdites une ou plusieurs premières parties de connexion (175) sont munies d'un ou de plusieurs trous de connexion (175a), et lesdites une ou plusieurs secondes parties de connexion (177) sont munies d'une ou de plusieurs saillies de rotation (177a), et dans lequel lesdites une ou plusieurs premières parties de connexion (175) et lesdites une ou plusieurs secondes parties de connexion (177) se chevauchent mutuellement et sont accouplées par lesdites une ou plusieurs saillies de rotation (177a) insérées dans lesdits un ou plusieurs trous de connexion (175a) ; et/ou
dans lequel l'élément de connexion (173) disposé à l'une des extrémités (170b) de l'élément pénétrant (170) à câble(s) et/ou l'élément de connexion (173) disposé à l'autre extrémité (170a) de l'élément pénétrant (170) à câble(s) est muni d'un trou de couplage (171) pour accoupler l'élément de connexion (173) à la plaque fixe (130) et/ou à la plaque mobile.

8. Dispositif d'affichage selon l'une quelconque des revendications précédentes, dans lequel l'élément d'entraînement (150) comprend :
un moteur d'entraînement (157) accouplé à la plaque fixe (130) ;
une roue menante (156) et une roue menée (154) mises en rotation par le moteur d'entraînement (157) ;
une poulie d'entraînement (153) accouplée à la roue menée (154) pour enrouler ou dérouler la courroie d'entraînement (151) ; et
une ou plusieurs poulies menées (155a, 155b) connectées à la poulie d'entraînement (153) par la courroie d'entraînement (151) et accouplées à la plaque fixe (130).

9. Dispositif d'affichage selon la revendication 8, dans lequel l'élément d'entraînement (150) comprend en outre :
une ou plusieurs barres de guidage (161a, 161b) fixées à l'enceinte modulaire (120) ; et
un ou plusieurs guides de déplacement (165a, 165b) accouplés à la plaque mobile (140) et configurés pour se déplacer le long desdites une ou plusieurs barres de guidage (161a, 161b), respectivement.

10. Dispositif d'affichage selon la revendication 9, dans lequel l'élément d'entraînement (150) inclut :
une ou plusieurs courroies élastiques (181), ayant chacune une extrémité (181a) accouplée audit/auxdits un ou plusieurs guides de déplacement (165a, 165b) et l'autre extrémité (181b) fixée à l'enceinte modulaire(120) ; et
un ou plusieurs rouleaux (183) de courroie fixés à la plaque fixe (130), et lesdites une ou plusieurs courroies élastiques (181) sont soutenues de manière à pouvoir tourner par lesdits uns ou plusieurs rouleaux (183) de courroie.

11. Dispositif d'affichage selon l'une quelconque des revendications précédentes, comprenant :
une porte coulissante (180) disposée dans l'ouverture de l'enceinte modulaire (120) et configurée pour fermer l'ouverture de l'enceinte modulaire (120) lorsque le panneau d'affichage (110) est rentré dans l'enceinte modulaire (120) et/ou pour ouvrir l'ouverture de l'enceinte modulaire (120) lorsque le panneau d'affichage (110) est sorti de l'enceinte modulaire (120), en étant coulissée dans une direction avant et une direction arrière de l'enceinte modulaire (120).

12. Dispositif d'affichage selon la revendication 11, dans lequel le dispositif d'affichage comprend en outre :
un ou plusieurs leviers (191) de porte, incluant chacun une extrémité accouplée à la porte coulissante (180) et l'autre extrémité accouplée, de manière à pouvoir tourner, à la plaque fixe (130).

13. Dispositif d'affichage selon la revendication 12, comprenant une ou plusieurs consoles (133) à charnière accouplées à la plaque fixe (130), dans lequel chacun des leviers (191) de porte est accouplé, de manière à pouvoir tourner, à la console (133) à charnière et est apte à tourner autour d'un axe (190h) de charnière ; et
dans lequel chacun des leviers (191) de porte inclut un trou de support (193), et un élément (197) permettant la rotation disposé au niveau du trou de support (193) ; et
dans lequel le dispositif d'affichage comprend une glissière (190) accouplée à la plaque mobile (140) et configurée pour permettre un mouvement de l'élément (197) permettant la rotation des leviers (191) de porte.

14. Dispositif d'affichage selon la revendication 13, dans lequel une rainure guide (194) dans laquelle est inséré l'élément (197) permettant la rotation est disposée à l'intérieur de la glissière (190) ; ou
dans lequel une rainure guide (194) dans laquelle est inséré l'élément (197) permettant la rotation est disposée à l'intérieur de la glissière (190), dans lequel la rainure guide (194) inclut une rainure guide supérieure (194t) et une rainure guide inférieure (194b) ayant des lignes centrales (C1, C2) parallèles, et dans lequel la rainure guide supérieure (194t) et la rainure guide inférieure (194b) sont reliées via une rainure courbée (194s) disposée entre celles-ci.

15. Ensemble comprenant une enceinte principale (10) et le dispositif d'affichage selon l'une quelconque des revendications précédentes, dans lequel l'enceinte modulaire (120) est intégrée dans et/ou fixée à l'enceinte principale (10), et dans lequel le panneau d'affichage (110) est mobile par rapport à l'enceinte principale (10) en étant sorti de et rentré dans l'enceinte modulaire (120) ; et/ou
dans lequel le panneau d'affichage (110), la plaque mobile (140) et la plaque fixe (130) sont séquentiellement empilés d'une face avant à une face arrière de l'enceinte modulaire (120).
